# EUROPEAN PATENT SPECIFICATION

(11) **EP 1 880 037 B1**
(45) Date of publication and mention of the grant of the patent: **15.06.2022**
(21) Application number: 06751378.8
(22) Date of filing: 26.04.2006
(51) Int. Cl.: C23C 16/30, C23C 14/22, C23C 14/24, C23C 14/56

(54) **SYSTEM AND METHOD FOR DEPOSITING A MATERIAL ON A SUBSTRATE**
SYSTEM UND VERFAHREN ZUR ABSCHEIDUNG EINES MATERIALS AUF EINEM SUBSTRAT
SYSTEME ET PROCEDE DE DEPOT D'UNE MATIERE SUR UN SUBSTRAT

(30) Priority: 25.04.2006 US 380073; 25.04.2006 US 380079; 25.04.2006 US 380088; 25.04.2006 US 380095; 26.04.2005 US 674676 P; 26.04.2005 US 674677 P; 26.04.2005 US 674683 P; 26.04.2005 US 675078 P
(43) Date of publication of application: 23.01.2008
(73) Proprietor: First Solar, Inc., Perrysburg, OH 43551 (US)
(72) Inventor: POWELL, Ricky, Ann Arbor, Michigan 48108 (US); GRAY, Andrew, Perrysburg, Ohio 43551 (US); COLEMAN, Todd, Wayne, Ohio 43466 (US)
(74) Representative: D Young & Co LLP
(86) International application number: PCT/US2006/015645
(87) International publication number: WO 2006/116411

(56) References cited:
- DE-C1- 4 408 052
- US-A- 594 642
- US-A- 3 858 548
- US-A- 5 445 973
- US-A- 5 837 320
- US-A- 6 037 241
- US-B1- 6 660 328

## Description

### TECHNICAL FIELD

The present invention relates to photovoltaic device production.

### BACKGROUND

In the manufacture of a photovoltaic device, semiconductor material is deposited on a glass substrate. This may be accomplished by vaporizing the semiconductor and directing the vaporized semiconductor towards the glass substrate surface, such that the vaporized semiconductor condenses and is deposited on the glass, forming a solid semiconductor film. Such a method is disclosed in US 6,037,241.

US 3,858,548 A discloses a vapor transport film deposition apparatus that relies on a central reactant furnace with a plurality of feeder furnaces connected around the circumference thereof. A substrate is disposed in the reactant furnace and subjected to vapours emanating from the feeder furnaces.

DE 44 08 052 C1 relates to the use of an apparatus for cluster beam production for coating a substrate.

### SUMMARY

In general, a method and system for depositing a semiconductor material on a substrate includes introducing a material and a carrier gas into a distributor assembly having a heated first chamber to form a vapor of the material. The material is a powder, for example, a powder of a semiconductor material. The carrier gas and vapor are then directed through a series of successive heated chambers to form a uniform vapor/carrier gas composition. The uniformity of the gas composition is provided by flow and diffusion of the vapor and gas incident to passing the vapor and gas through a plurality of chambers of the distributor assembly. After the composition has become uniform, it is directed out the distributor assembly through an orifice of a nozzle and towards a substrate, causing a film to be formed on a surface of substrate. The substrate can be a glass substrate or another suitable substrate such as polymer substrate having a surface suitable for forming a uniform film. The film can be a semiconductor composition. The vapor and carrier gas composition may be passed through a filter after being introduced into the distributor assembly in order to ensure that solid particles of that material are not directed toward the substrate. Advantageously, the method and system for depositing a semiconductor material provides a semiconductor film with improved film thickness uniformity and grain structure uniformity.

In one aspect, a method for depositing a film on a substrate includes directing a powder such as cadmium sulfide or cadmium telluride and an inert carrier gas such as helium through a feed tube into a heated distributor assembly including a network of sequentially connected chambers. In particular the present invention provides a method as defined in Claim 1.

The distributor assembly may include a plurality of successively shrouded tubes such that the semiconductor powder and inert gas are introduced through a feed tube into a first heated tube (the first chamber) the interior of which is passably connected to the interior of a second chamber. The first heated tube is heated such that the semiconductor powder forms a vapor. The vapor and carrier gas are then directed from the first heated tube to the second chamber, which may itself be a heated tube, and which may be a heated tube larger than the first heated tube and provided such that the first heated tube is disposed within the second tube. The distributor assembly may also include a filter formed such that semiconductor vapor and carrier gas are able to pass through the filter, but semiconductor powder cannot. The vapor and carrier gas are directed through the filter to filter out semiconductor powder.

Chambers included in the distributor assembly define multiple flow paths. For example, the space between the exterior of the first heated tube (first chamber) and the interior of a second tube (second chamber) surrounding the first heated tube defines a flow path. Movement of the vapor and carrier gas through multiple flow paths of the distributor assembly creates a flow which results in a uniform mixing of vaporized semiconductor and inert carrier gas. Additionally, passing the vapor and carrier gas through multiple flow paths can require the vapor to travel a greater distance to the substrate and can allow more time for the powder to completely vaporize. The method may also include passing the vapor through a filter or other barrier permeable to vapor but not to powder to ensure that no powder is deposited on a surface of the substrate. Reducing or substantially eliminating the amount of powder from the vapor/carrier gas composition and providing a uniform vapor/carrier gas composition results in a deposited film that is substantially uniform as to both thickness and grain structure, resulting in higher-quality and lower-cost production.

The method also includes passing the vapor and carrier gas between external heater tubes when directing the vapor towards a surface of a substrate. Passing the vapor and carrier gas between external heater tubes maintains the vapor in a temperature sufficient to keep the vapor in a vaporized state until the vapor contacts the substrate, which is maintained at a lower temperature at which the vapor condenses and is deposited as a film on a surface of the substrate.

In another aspect, the present invention provides a distributor assembly as defined in Claim 7. In another aspect, the present invention provides a system for depositing a film on a substrate as defined in Claim 8. The system includes a material source connected to the distributor assembly (e.g. feed tube) through which the powder and carrier gas are introduced into the first chamber of the distributor assembly. The distributor assembly may be heated by applying a current across one or more chambers included in the distributor assembly, or by another means that will heat at least a portion of the distributor assembly to a temperature sufficient to form a vapor from the powder. A heating element is provided in the first chamber. The system may also include a filter or other barrier permeable to vapor but not powder to substantially prevent powder from exiting the distributor assembly and being deposited on a surface of a substrate. The filter may be positioned within the first chamber.

The chambers in the distributor assembly are provided such that the vapor and carrier gas travel along multiple flow paths defined by chambers included in the distributor assembly. A first flow path may be provided proximate to the first chamber. After the powder introduced into the first chamber is vaporized, the vapor and carrier gas are directed into the proximate first flow path. A second flow path may be provided proximate to the first flow path. Vapor and carrier gas from the first flow path are directed from the first flow path to the proximate second flow path. The first and second flow paths provide a flow pattern for the vapor and carrier gas such that the vapor and carrier gas diffuse and a uniform vapor/carrier gas composition is obtained as the vapor and carrier gas are directed through flow paths defined within and between the chambers included in the distributor assembly. The chambers included in the distributor assembly may be provided as a plurality of successively shrouded tubes such that the vapor and carrier gas are introduced into a first chamber which is a tube disposed within (e.g., shrouded by) another tube (the second chamber). The shrouded tube (first chamber) includes one or more apertures through which the vapor and carrier gas are directed from the shrouded tube to the shroud tube (second chamber).

The distributor assembly may also include flow paths defined by non-tubular chambers used in connection with tubular chambers or other non-tubular chambers. Additionally, the distributor assembly may be designed such that the vapor and carrier gas are directed through multiple flow paths from one chamber to the next through a passageway and not necessarily immediately through an aperture in a shrouded chamber into the interior of a shrouding chamber. Regardless of the specific configuration of the distributor assembly, the distributor assembly can provide a flow pattern for the vapor and carrier gas such that a uniform vapor/carrier gas composition is obtained as the vapor and carrier gas are directed within each chamber and between the chambers included in the distributor assembly. An outlet can be provided at the end of the distributor assembly and is positioned such that the uniform vapor/carrier gas composition directed through the distributor assembly and outlet is directed toward a surface of a substrate upon which the semiconductor is deposited as a film on a surface of the substrate. The outlet may be positioned proximate to the second flow path defined by a second chamber. As the last chamber through which the vapor/carrier gas composition is directed (second chamber) can be a tube, the outlet may be a slot oriented along the length of the tube. The outlet may also include a manifold having a plurality of orifices through which the vapor and carrier gas are directed toward the substrate.

The distributor assembly also includes external heater tubes proximate to the outlet. When the vapor and carrier gas pass between these external heaters, the vapor is maintained at a sufficient temperature to keep the vapor in a vapor states until it contacts a surface of the substrate, which is maintained at a lower temperature, causing the vapor to condense and be deposited on a surface of the substrate as a film.

The substrate upon which the film is deposited can be introduced in the proximity of the distributor assembly outlet by a conveyor system. The system provided by the present invention includes a conveyor for transporting the substrate sufficiently proximate to the distributor assembly such that the vapor may be deposited on the substrate as a film. The conveyor may include a gas hearth for supporting and transporting a plurality of substrates past the distributor assembly outlet for deposition.

The method and system described here have the advantage over known systems and methods of depositing a semiconductor film on a substrate of providing a film of uniform thickness and grain structure. These properties can be important, particularly with respect to the use of semiconductor films in solar panels. The method and system described here also provide improved definition of the film deposition area, resulting in higher material utilization. As a result, the method and system described result in higher efficiency in the production of solar panels than is provided with known methods and systems.

The method can provide a material film having a uniform thickness and composition. A solid (powder) introduced into the system can be maintained at a temperature sufficient to vaporize the material for a duration of time sufficient to ensure that substantially all the material that is passed through the system forms a vapor, and the vapor and carrier gas can be directed through a filter, while the unvaporized solid cannot pass through the filter. The filtered product includes substantially no solid material, thereby preventing solid material from being directed toward a surface of a substrate and resulting in an irregular resulting film. Additionally, a solid to be vaporized (powder) and a carrier gas introduced into the system are passed through the system in such a manner that the vapor and the carrier gas mix to form and maintain a uniform composition; segregation between the vapor and the carrier gas which can occur when passing through a permeable structure such as a filter on account of the difference in molecular weight between the vapor and carrier gas is substantially reduced.

The details of one or more embodiments are set forth in the accompanying drawings and the description below. Other features, objects, and advantages will be apparent from the description and drawings, and from the claims.

### DESCRIPTION OF DRAWINGS

FIG. 1 is a drawing depicting a system for depositing a semiconductor on a glass sheet substrate.
FIG. 2 is a drawing depicting a material supply for introducing a semiconductor powder and a carrier gas into a distributor assembly.
FIG. 3 is a drawing depicting an embodiment of a material supply.
FIG. 4 is a drawing depicting an alternate embodiment of a material supply.
FIG. 5 is a drawing depicting an embodiment of a system for depositing a semiconductor on a downward-facing surface of a glass sheet substrate.
FIG. 6 is a drawing depicting an embodiment of a distributor assembly.
FIG. 7 is a drawing depicting an embodiment of a distributor assembly.
FIG. 8 is a drawing depicting an embodiment of a distributor assembly.
FIG. 12 is a drawing depicting an embodiment of a distributor assembly.
FIG. 13 is a drawing depicting an embodiment of a distributor assembly.
FIG. 15A is a drawing depicting a first view of an embodiment of a distributor assembly.
FIG. 15B is a drawing depicting a second view of an embodiment of a distributor assembly of FIG 15A.

### DETAILED DESCRIPTION

An apparatus and method for depositing a semiconductor film on a glass substrate are described, for example, in U.S. Patent No. 6,037,241.

A solid material (powder) such as a semiconductor powder, and carrier gas can be introduced into a heated permeable tubular chamber (first chamber), where the solid material (powder) is vaporized. The vapor and carrier gas then pass through the walls of the heated permeable chamber into a shroud (second chamber) surrounding the first chamber. The second chamber includes an opening through which the vapor is directed toward a surface of a substrate, such as a glass substrate, where it is deposited as a film.

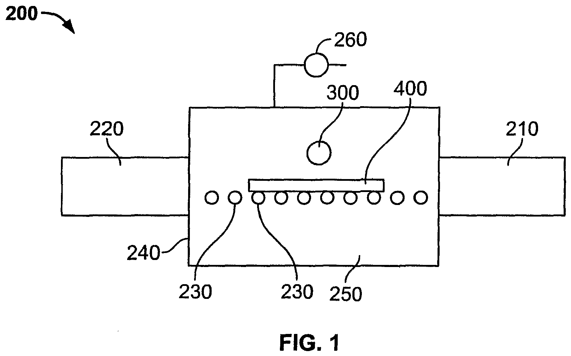

With reference to FIG. 1 of the drawings, a substrate processing system 200 includes distributor assembly 300. Both the distributor assembly 300 and the method for processing a substrate 400 are described and exemplified here.

With continuing reference to FIG. 1, the system 200 includes a housing 240 defining a processing chamber 250 in which a material is deposited on a substrate 400. Substrate 400 can be a glass sheet. Housing 240 includes an entry station 210 and an exit station 220. Entry station 210 and exit station 220 can be constructed as load locks or as slit seals through which substrate 400 enters and exits the processing chamber 250. The housing 240 can be heated in any suitable manner such that its processing chamber can be maintained at a deposition temperature. The distributor temperature can be about 500 degrees to about 1200 degrees C. Substrate 400 can be heated during the processing to a substrate temperature. The substrate temperature can be 200 degrees to 650 degree C. Substrate 400 is transported by any appropriate means such as rollers 230, or a conveyor system, preferably driven by an attached electric motor.

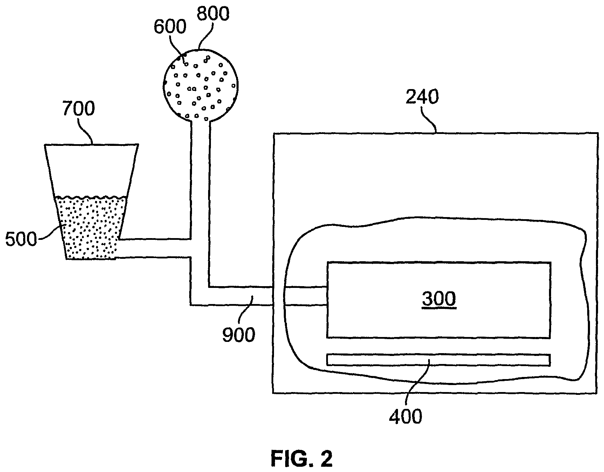

With reference to FIG. 2, distributor assembly 300 contained in housing 240 is connected by feed tube 900 to a material supply, which can include a hopper 700 containing a powder 500 and a carrier gas source 800 containing an appropriate carrier gas 600. Powder 500 can contact carrier gas 600 in feed tube 900, and both carrier gas 600 and powder 500 are introduced into distributor assembly 300.

After carrier gas 600 and powder 500 are introduced into distributor assembly 300, powder 500 is vaporized and directed through distributor assembly 300 along with carrier gas 600 in such a manner that carrier gas 600 and the vapor are mixed to form a uniform vapor/carrier gas composition. The uniform vapor/carrier gas composition is then directed out of distributor assembly 300 toward substrate 400. The lower temperature of substrate 400 compared to the temperature in distributor assembly 300 in order to maintain the material in vapor phase, causes condensation of the vapor on a surface of substrate 400, and the deposition of a film, which has a substantially uniform thickness and a substantially uniform structure demonstrating a uniform crystallization and a substantial absence of particulate material, such as unvaporized powder.

The exit point of the semiconductor vapor from distributor assembly 300 can be spaced from substrate 400 at a distance in the range of about 0.5 to about 5.0 cm to provide more efficient deposition. While greater spacing can be utilized, that may require lower system pressures and would result in material waste due to overspraying. Furthermore, smaller spacing could cause problems due to thermal warpage of substrate 400 during conveyance in the proximity of the higher temperature distributor assembly 300. Substrate 400 can pass proximate to the point where the semiconductor vapor exists distributor assembly 300 at a speed of at least about 20 mm per second to about 40 mm per second.

In performing the deposition, successful results have been achieved using cadmium telluride and cadmium sulfide as the material (powder). However, it should be appreciated that other materials can be utilized which include a transition metal (Group IIB) and a chalcogenide (Group VIA). It should be further appreciated that additional materials that can be utilized to form a semiconductor film have many useful applications (such as the manufacture of photovoltaic devices) and may be used with the systems and methods described herein. Also, dopants may be useful to enhance the deposition and properties of the resulting film.

Use of system 200 to perform the method has been performed with a vacuum drawn in the processing chamber 250 to about 0.5 to 760 Torr. In that connection, as illustrated in FIG. 1, the processing system 200 includes a suitable exhaust pump 260 for exhausting the processing chamber 250 of the housing 240 both initially and continuously thereafter to remove the carrier gas.

The carrier gas 600 supplied from the source 800 can be helium, which has been found to increase the glass temperature range and the pressure range that provide film characteristics such as deposition density and good bonding. Alternatively, the carrier gas can be another gas such as nitrogen, neon, argon or krypton, or combinations of these gases. It is also possible for the carrier gas to include an amount of a reactive gas such as oxygen that can advantageously affect growth properties of the material. A flow rate of 0.3 to 10 standard liters per minute of the carrier gas has been determined to be sufficient to provide the material flow to distributor assembly 300 for deposition on a substrate.

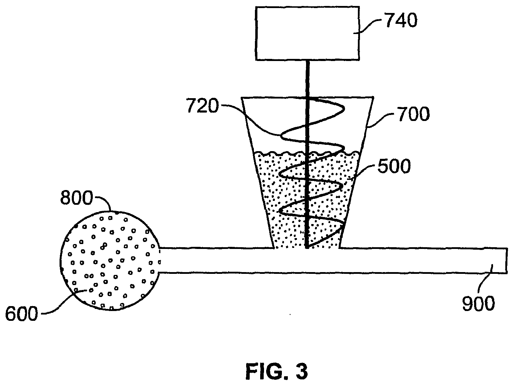

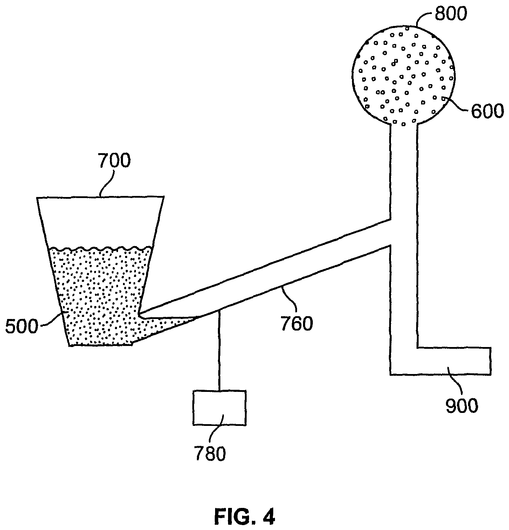

It should be recognized that multiple material supplies having multiple hopper and multiple carrier gas sources may introduce carrier gas and material into the distributor assembly. A single material supply is shown in FIG. 2 and subsequent figures for the sake of clarity. FIG. 3 and FIG. 4 depict alternate embodiments of a material supply which can be used. As shown in FIG. 3, hopper 700 containing powder 500 may include a rotary screw 720, which, when rotated by actuator 740 delivers powder 500 into feed tube 900, where it is introduced into carrier gas 600 delivered from carrier gas source 800. Alternatively, as shown in FIG. 4, a vibration-actuated material source is depicted, in which a vibration introduced by vibratory feeder 780 causes powder 500 to incrementally move from hopper 700 into inclined passage 760. In this manner, powder is introduced into feed tube 900, along with carrier gas 600 from carrier gas source 800.

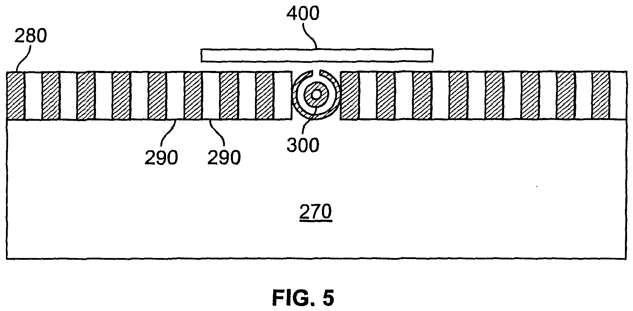

FIG. 5 represents an alternative embodiment of system 200 in which a semiconductor film may be deposited on a downward-facing surface of substrate 400. The alternate system depicted includes a refractory hearth 280 above a plenum 270 of heated pressurized gas. Holes 290 in hearth 280 provide for upward flow of the pressurized heated gas so as to support glass substrate 400 in a floating manner. As floating glass substrate 400 is conveyed along the length of hearth 280, the downward-facing surface passes proximate to distributor assembly 300, from which semiconductor vapor is directed toward and deposited as a film on substrate 400.

Various embodiments of distributor assembly 300 are described below.

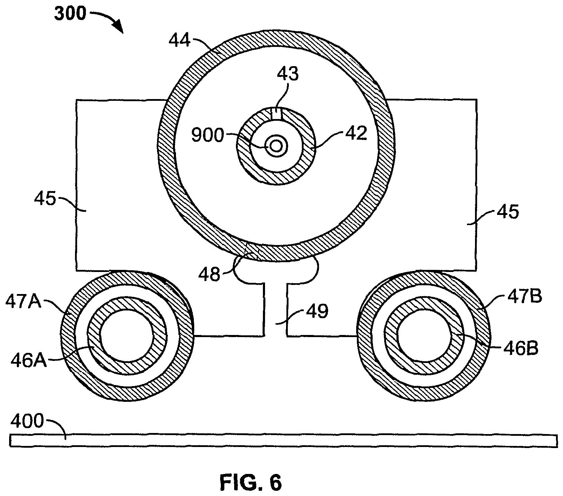

Referring to FIG. 6, one embodiment of distributor assembly 300 is described with reference to its internal components. As described above, a carrier gas and material are introduced into distributor assembly 300 through feed tube 900 which can be formed from mullite, and which can have an outer diameter of about 5 mm to about 15 mm (preferably about 10 mm), and an inner diameter of about 5 mm to about 10 mm (preferably about 6 mm). Carrier gas and material are first directed into the interior of a first chamber, heater tube 42, which can be impermeable and can have an outer diameter of about 15 mm to about 54 mm (preferably about 19 mm), and an inner diameter of about 10 mm to about 15 mm (preferably about 13 mm). First chamber 42 can be formed from graphite or silicon carbide (SiC), and can be resistively heated by applying a current across first chamber 42. When the material introduced into the interior of heater tube first chamber 42 is a cadmium chalcogenide material, first chamber 42 can be heated to a temperature of about 500 degrees C to about 1200 degrees C to vaporize the cadmium chalcogenide. If first chamber 42 is formed from graphite, first chamber 42 can be heated to a temperature of about 1200 degrees to about 1500 degrees C when the material is a cadmium chalcogenide. This higher temperature vaporizes cadmium chalcogenide material more quickly. Forming first chamber 42 from graphite allows higher temperatures to be utilized since it provides resistance against deterioration potentially caused by the vapor in this temperature range.

As new material and carrier gas are introduced into first chamber 42, the vapor and carrier gas are directed out of first chamber 42 through outlet 43, which can be a single hole, and which can have diameter of about 2 mm to about 20 mm (preferably about 3 mm), into a second chamber, distribution manifold 44. Outlet 43 can also represent a plurality of distribution holes. Second chamber 44 can be composed of graphite or mullite, or another suitable ceramic, and can have an outer diameter of about 75 mm to about 100 mm (preferably about 86 mm) and an inner diameter of about 50 mm to about 80 mm (preferably about 70 mm).

Second chamber 44 is positioned above glass substrate 400 by a cradle 45, which can be formed from graphite, such that the length of second chamber 44 covers at least a portion of the width of substrate 400 as substrate 400 is conveyed beneath second chamber 44. The vapor and carrier gas travel within and along the length of second chamber 44 until the vapor and carrier gas form a uniform vapor/carrier gas composition. Next, the uniform vapor/carrier gas composition is directed out of second chamber 44 through a plurality of distribution holes 48 aligned in a row along the length of distribution manifold 44. Distribution holes 48 can number about 20 to about 50 and can have a diameter of about 1 mm to about 5 mm (preferably about 3 mm). The number of distribution holes 48 included in distributor assembly 300 can be varied as required, and can be spaced from about 19 mm to about 25 mm apart. The uniform vapor/carrier gas composition is then directed into a nozzle 49 formed by graphite cradle 45, after which the vaporized semiconductor is deposited on underlying substrate 400, which can be a glass sheet substrate. Directing the uniform vapor/gas composition streams emitted from distribution holes 48 into a portion of cradle 45, as depicted in FIG. 6 disperses the uniform vapor/gas composition and further increases its uniformity of composition, pressure and velocity in preparation for deposition on underlying substrate 400.

As shown in FIG. 6, graphite cradle 45 is adjacent to external heater tubes 46A and 46B, which can be resistively heated silicon carbide (SiC) tubes, and which can have an outer diameter of about 25 mm to about 75 mm (preferably about 54 mm). External heater tubes 46A and 46B can be positioned inside external heater tube shrouds 47A and 47B, which can be formed from mullite. External heater tubes 46A and 46B heat graphite cradle 45. Additionally, after the uniform vapor/carrier gas composition is directed out of nozzle 49, the uniform vapor/carrier gas composition passes proximate to external heater tubes 46A and 46B. Both the heating of cradle 45 and the proximity of external heater tubes 46A and 46B to uniform vapor/carrier gas composition exiting distributor assembly 300 at nozzle 49 maintains the uniform vapor/carrier gas composition at a temperature sufficient to maintain the vapor in a vapor state. A temperature of about 500 degrees C to about 1200 degrees C is sufficient to maintain the vapor in a vapor state, where the starting material is a cadmium chalcogenide.

As substrate 400 is conveyed by the orifice of nozzle 49, the uniform vapor/carrier gas composition is directed toward surface of substrate 400, which is maintained at a lower temperature such that the vapor condenses and is deposited on a surface of substrate 400 as a film. The proximity of substrate 400 to nozzle 49 increases the efficiency of depositing the film by reducing the amount of material wasted.

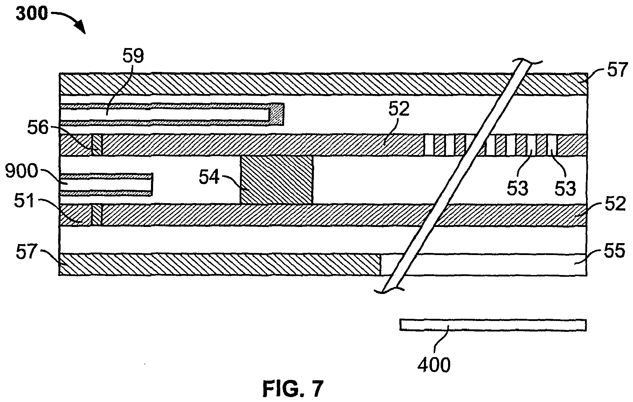

FIG. 7 depicts a cross section view taken along the length of a distributor assembly 300. A carrier gas and a powder are introduced through feed tube 900 into heater tube 52 (first chamber). Heater tube 52 can be resistively heated by applying current across the length of heater tube 52 and is preferably formed from substantially impermeable graphite or SiC. The powder and carrier gas are heated in heater tube 52, causing the powder to vaporize. The vapor and carrier gas are then directed through filter 54 provided in heater tube 52. Filter 54 can be formed from a material that is permeable to the carrier gas and vapor, but not to the powder, thereby ensuring that no powder is ultimately deposited on the substrate. Heater tube 52 may be joined by internal joints 56 to low-resistance electrified ends 51, which are not permeable.

After the vapor and carrier gas are directed through filter 54, the mixture is directed into a portion of heater tube 52 having a plurality of outlets 53, which are preferably holes drilled in a line on one side of heater tube 52. The vapor and carrier gas are then directed through outlets 53 into the interior of an outer tubular sheath 57 (second chamber) which shrouds heater tube 52. Outer tubular sheath 57 can be formed from mullite. During the passage through heater tube 52 and into and within outer tubular sheath 57, the irregular flow of the vapor and carrier gas results in continuous mixing and diffusion of the vapor and the carrier gas to provide a uniform vapor/carrier gas composition. As shown in FIG. 7, the interior of outer tubular sheath 57 can include a thermowell 59 for monitoring the temperature of distributor assembly 300.

The uniform vapor/carrier gas composition is directed within the interior of outer tubular sheath 57 and toward a slot 55, which is preferably located on the side of outer tubular sheath substantially opposite outlets 53 to provide a lengthy and indirect pathway for the vapor and carrier gas, thereby dispersing the streams of uniform vapor/carrier gas composition directed from outlets 53 and promoting maximum mixing and uniformity of gas composition, pressure and velocity. The uniform vapor/carrier gas composition is directed out of outer tubular sheath 57 through slot 55 and the film of material is deposited on underlying substrate 400.

It should be appreciated that FIG. 7 depicts a portion of distributor assembly 300 and an additional feed tube and internal filter may be provided at an opposite end of distributor assembly 300, which is not shown in FIG. 7.

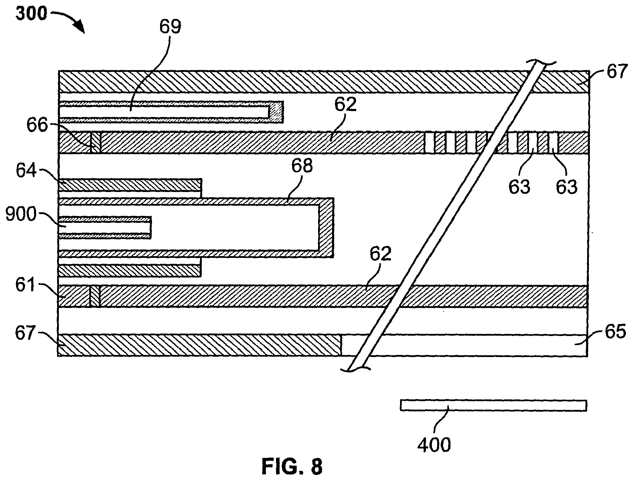

FIG. 8, like FIG. 7, depicts a cross section view taken along the length of a distributor assembly 300. According to this embodiment, a carrier gas and a powder are introduced through feed tube 900 into heater tube 62 (first chamber). Feed tube 900 can be formed from mullite or aluminum oxide and can have an outer diameter of about 5 mm to about 15 mm (preferably about 7 mm), and an inner diameter of about 3 mm to about 10 mm (preferably about 5 mm). Heater tube 62 can be resistively heated by applying a current across the length of heater tube 62 and can be formed from graphite or SiC. Heater tube 62 can have an outer diameter of about 25 mm to about 75 mm (preferably about 54 mm), and an inner diameter of about 20 mm to about 50 mm (preferably about 33 mm). The powder and carrier gas are heated in heater tube 62, causing the powder to vaporize.

In contrast to the embodiment described above in which the vapor and carrier gas were directed through an internal filter, in the embodiment described with reference to FIG. 8, after heating, the vapor and carrier gas are then directed through cantilevered internal filter 68 which is formed from SiC and is permeable to the vapor and the carrier gas. Internal filter 68 can have an outer diameter of about 10 mm to about 30 mm (preferably about 20 mm), and an inner diameter of about 5 mm to about 15 mm (preferably about 9 mm). The vapor and carrier gas are directed through cantilevered internal filter 68 into the interior of heater tube 62. Isolation sleeve 64 is provided to prevent electrical arcs between cantilevered internal filter 68 and heated sleeve 64, resulting in heater failure. Isolation sleeve 64 can be made from a non-conductive material such as mullite or aluminum oxide and can have an outer diameter of about 20 mm to about 40 mm (preferably about 32 mm), and an inner diameter of about 20 mm to about 30 mm (preferably about 25 mm). Heater tube 62 may be joined by internal joints 66 to low-resistance electrified ends 61.

The vapor and carrier gas are then directed through a plurality of outlets 63, which can be drilled holes formed in a line on one side of heater tube 62. Outlets 63 can have a diameter of about 2 mm to about 5 mm (preferably about 3 mm), and can number about 15 to about 40 along the length of heater tube 62 and can be spaced about 19 mm to about 25 mm apart. The vapor and carrier gas enter the interior of an outer tubular sheath 67 (second chamber), which shrouds heated tube 62. Outer tubular sheath 67 can be formed from mullite. During the passage through heater tube 62 and into and within outer tubular sheath 67, the irregular flow of the vapor and carrier gas results in continuous mixing and diffusion of the vapor components and carrier gas to form a uniform vapor/carrier gas composition. The interior of outer tubular sheath 67 can also include a thermowell 69, which can be formed from aluminum oxide and can have an outer diameter of about 5 mm to about 10 mm (preferably about 7 mm), for monitoring the temperature of distributor assembly 300.

The uniform vapor/carrier gas composition is directed within the interior of outer tubular sheath 67, dispersing the streams of vapor and carrier gas directed from outlets 63 and increasing the uniformity of composition, pressure and velocity of the vapor and carrier gas. The uniform vapor/carrier gas composition is directed and toward a slot 65, which can be located on a side of outer tubular sheath 67 substantially opposite outlets 63 to provide a lengthy and indirect path for the vapor and carrier gas, thereby promoting maximum mixing and uniformity of the vapor/carrier gas composition. The uniform vapor/carrier gas composition is directed out of outer tubular sheath 67 through slot 65 and is deposited on a surface of underlying substrate 400.

It should be appreciated that as with FIG. 7, FIG. 8 depicts a portion of distributor assembly 300 and an additional feed tube and cantilevered internal filter may be provided at an opposite end of distributor assembly 300, which is not shown in FIG. 8.

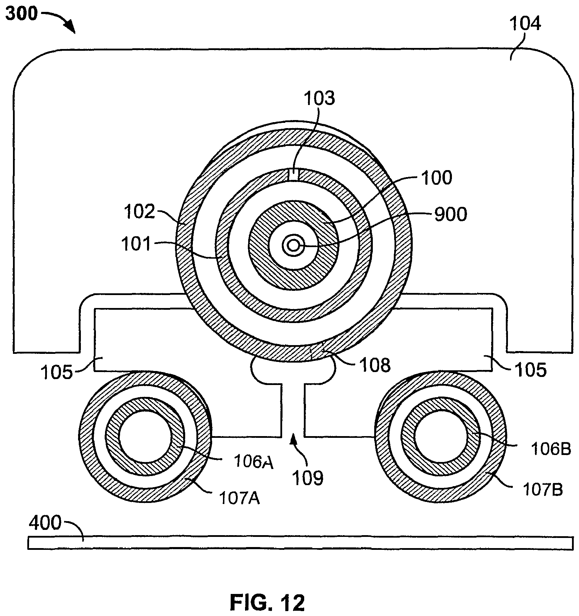

Referring now to FIG. 12, an alternate embodiment of a distributor assembly 300 is depicted. A powder and carrier gas are introduced into the interior of heater tube 100 (first chamber). Heater tube 100 is heated to a temperature sufficient to vaporize the powder as it travels within and along the length of heater tube 100. Heater tube 100 can be resistively heated, and can be formed from SiC. Heater tube 100 is permeable to the vapor and carrier gas, but not to the powder. As the powder is vaporized in heater tube 100, it begins to form a uniform vapor/carrier gas composition with the carrier gas.

The vapor and carrier gas permeate through heater tube 100 into tubular sheath 101 (second chamber), which surrounds heater tube 100 and can be formed from mullite. The vapor and carrier gas are directed within tubular sheath 101, which causes the vapor and carrier gas to continually mix. The vapor and carrier gas are then directed toward outlet 103, which can be a single drilled hole formed in tubular sheath 101. As the vapor and carrier gas are directed through outlet 103, they are remixed even further, contributing to an increasingly uniform vapor/carrier gas composition.

The mixed vapor and carrier gas travel through outlet 103 into the interior of distribution manifold 102, which, like tubular sheath 101, can be formed from mullite or graphite. Distribution manifold 102 may be encased or surrounded by an insulation such as a fiber blanket insulation 104 for retaining heat generated by permeable heated tube 100, thereby reducing the energy required to maintain the temperature required to vaporize the powder. Distribution manifold 102 can be supported by a cradle 105, which can be formed from graphite. Cradle 105 is heated by external heater tubes 106A and 106B, which can be formed from SiC and resistively heated, and located inside external heater tube sheaths 107A and 107B, which can be formed from mullite and which conduct heat generated by external heater tubes 106A and 106B to the adjacent cradle 105.

After the uniform vapor/carrier gas composition is directed through outlet 103 in tubular sheath 101, the vapor and carrier gas continue to mix as they are directed through the space between the interior wall of distribution manifold 102 and the exterior of tubular sheath 101. The uniform vapor/carrier gas composition is directed to a plurality of distribution holes 108 located at a position in distribution manifold 102 substantially opposite the position on tubular sheath 101 at which outlet 103 is located. The plurality of distribution holes 108 can be aligned along at least a portion of the length of distribution manifold 102. The uniform vapor/carrier gas composition is directed through distribution holes 108 toward a portion of graphite cradle 105, dispersing streams of uniform vapor/carrier gas composition directed through distribution holes 108 and further increasing the uniformity of the vapor/carrier gas with respect to composition, pressure, and velocity. In addition to heating graphite cradle 105, external heater tubes 106A and 106B are also proximate to nozzle 109 through which the uniform vapor/carrier gas composition is directed out of distributor assembly 300. Both the heating of cradle 105 and the proximity of external heater tubes 106A and 106B to uniform vapor/carrier gas composition exiting distributor assembly 300 at nozzle 109 maintains the uniform vapor/carrier gas composition at a temperature sufficient to maintain the vapor in a vapor state. A temperature of about 500 degrees C to about 1200 degrees C is sufficient to maintain the vapor in a vapor state, where the starting material is a cadmium chalcogenide.

As substrate 400 is conveyed by the orifice of nozzle 109, the uniform vapor/carrier gas composition is directed toward surface of substrate 400, which is maintained at a lower temperature such that the vapor condenses and is deposited on a surface of substrate 400 as a film.

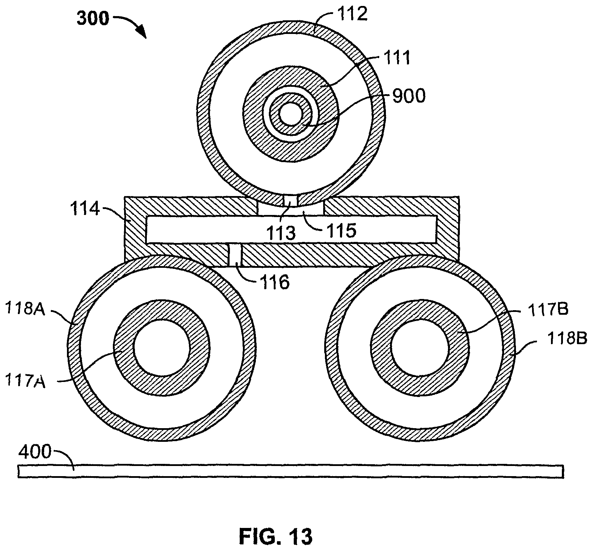

Referring now to FIG. 13, an alternate embodiment of a distributor assembly 300 is depicted. A powder and a carrier gas are introduced into the interior of heater tube 111 (first chamber). Heater tube 111 is heated to temperature sufficient to vaporize the powder as it travels within and along the length of permeable heated tube 111. Heater tube 111 can be resistively heated, and can be formed from SiC. Heater tube 111 is permeable to the vapor and carrier gas, but not to the powder.

The vapor and carrier gas permeate through permeable heater tube 111 into outer tubular sheath 112 (second chamber), which surrounds permeable heater tube 111 and can be formed from mullite. The forming uniform vapor/carrier gas composition is directed within outer tubular sheath 112, which causes the vapor and carrier gas to continually mix. The uniform vapor/carrier gas composition is then directed toward outlet 113, which can be a single drilled hole formed in outer tubular sheath 112. As the semiconductor vapor and carrier gas are directed through outlet 113, they are remixed even further, contributing to an increasingly uniform vapor/carrier gas composition.

The uniform vapor/carrier gas composition is directed through outlet 113 into the interior of manifold 114, which includes a passageway 115 connecting the interior of manifold 114 with outlet 113 formed in outer tubular sheath 112. Manifold 114 is adjacent to external heater tubes 117A and 117B, which can be formed from SiC and resistively heated, and located inside external heater tube sheaths 118A and 118B, which can be formed from mullite and which conduct heat generated by external heater tubes 117A and 117B to the adjacent manifold 114. As the vapor and carrier gas travel within manifold 114, they continue to remix, maintaining a uniform vapor/carrier gas composition.

As new vapor and carrier gas are introduced into the interior of manifold 114 through passageway 115, the uniform vapor/carrier gas composition is directed out of manifold 114 through a plurality of distribution holes 116, which can be arranged in a line parallel to the length of one of the external heater tube sheaths 118A, and is directed such that the flow of the uniform vapor/carrier gas composition is interrupted by external heater tube sheath 118A, which disperses the streams of uniform vapor/carrier gas composition directed from distribution holes 116 and further increases the uniformity of the composition, pressure, and velocity of the vapor/carrier gas. External heater tubes 117A and 117B conduct heat to manifold 114 and are also proximate to the flow of the uniform vapor/carrier gas composition directed out of distribution holes 116. Both the heating of manifold 114 and the proximity of external heater tubes 117A and 117B to uniform vapor/carrier gas composition exiting distributor assembly 300 at distribution holes 116 maintains the uniform vapor/carrier gas composition at a temperature sufficient to maintain the vapor in a vapor state. A temperature of about 500 degrees C to about 1200 degrees C is sufficient to maintain the vapor in a vapor state, where the starting material is a cadmium chalcogenide.

External heater tube sheaths 118A and 118B also form a path through which the uniform vapor/carrier gas composition is directed toward a surface of a substrate 400. As substrate 400 is conveyed by the path created by external heater tube sheaths 118A and 118B, the uniform vapor/carrier gas composition is directed toward surface of substrate 400, which is maintained at a lower temperature such that the vapor condenses and is deposited on a surface of substrate 400 as a film.

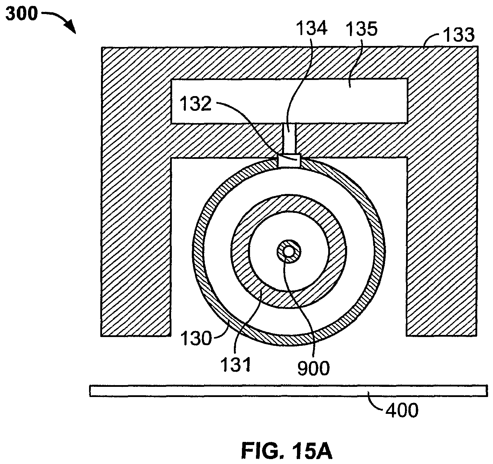

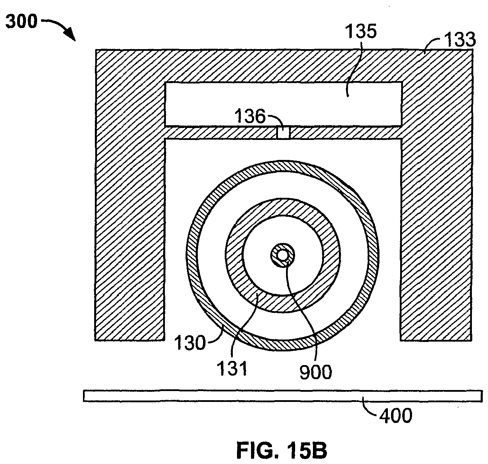

Referring now to FIG. 15A and FIG. 15B, an alternate embodiment of a distributor assembly 300 is depicted. A powder and a carrier gas are directed into the interior of heater tube 131 (first chamber) via feed tube 900, which can be formed from mullite, and which can have an outer diameter of about 5 mm to about 15 mm (preferably about 10 mm), and an inner diameter of about 5 mm to about 10 mm (preferably about 6 mm). Heater tube 131 is resistively heated to a temperature sufficient to vaporize the powder and is permeable to the resulting vapor and the carrier gas, but impermeable to the powder. Consequently, any powder that is not vaporized is unable to pass from the interior of heater tube 131. Heater tube 131 can be formed from SiC, and can have an outer diameter of about 30 to about 70 mm (preferably about 54 mm), and an inner diameter of about 25 mm to about 50 mm (preferably about 33 mm).

After the powder is vaporized to form a vapor, the vapor and carrier gas permeate the walls of heater tube 131 and are directed to the space between heater tube 131 and tubular sheath 130 (second chamber), which can be formed from graphite, mullite, or another suitable ceramic, and which has an outer diameter of about 60 mm to about 120 mm (preferably about 85 mm), and an inner diameter of about 50 mm to about 100 mm (preferably about 75 mm). Passage within tubular sheath 130 causes the vapor and carrier gas to mix to form a uniform vapor/carrier gas composition. The uniform vapor/carrier composition is directed through outlet 132 formed in tubular sheath 130. Outlet 132 can be a single drilled hole with a diameter of about 5 mm to about 20 mm (preferably about 13 mm) and the vapor and carrier gas are further remixed as they pass through outlet 132.

As shown in FIG. 15A, the uniform vapor/carrier gas composition directed through outlet 132 is then directed through hole 134 with a diameter of about 5 mm to about 20 mm (preferably about 13 mm) and into passageway 135, formed in block 133, which can be made of graphite, or mullite, or another suitable ceramic. The uniform vapor/carrier gas composition is directed through passageway 135.

Referring now to FIG. 15B, the uniform vapor/carrier gas composition directed through passageway 135 is directed out a plurality of distribution holes 136, which is formed in block 133 and which can be colinear to hole 134 along the length of block 133. Distribution holes 136 can be drilled, can have a diameter of about 1 mm to about 5 mm (preferably about 3 mm), and can number from about 10 to about 50 along the length of block 133, about 10 mm to about 25 mm (preferably about 19 mm) apart. The uniform vapor/carrier gas composition can be directed through distribution holes 136 toward a portion of tubular sheath 130, which disperses streams of uniform vapor/carrier gas composition directed from distribution holes 136 and further increases the uniformity of the vapor/carrier gas with respect to composition, pressure, and velocity. The uniform vapor/carrier gas composition is directed through a space formed by the outside of tubular sheath 130 and the interior of walls of block 133 towards underlying substrate onto which the vapor is deposited as a film.

The embodiments described above are offered by way of illustration and example. It should be understood that the examples provided above may be altered in certain respects and still remain within the scope of the claims. For example, the component dimensions described above are suitable for use with substrates up to 60 cm wide; adjustments can be made when using substrates of different sizes. It should be appreciated that, while the invention has been described with reference to the above preferred embodiments, other embodiments are within the scope of the claims.

## Claims

1. A method for depositing a material on a substrate (400), comprising:
introducing a powder (500) and a carrier gas (600) into a first chamber (42, 52, 62, 100), wherein the first chamber is a heated tube;
heating the powder such that at least a portion of the powder vaporizes into a vapor; wherein the first chamber comprises one or more first chamber walls which are permeable to the vapor and the carrier gas but impermeable to the powder;
directing a mixture of the vapor and carrier gas through the one or more first chamber walls of the first chamber and into a second chamber (44, 57, 67, 101), wherein the second chamber is tubular and is positioned outside the first chamber so that the second tubular chamber sheaths at least a portion of the first chamber, and the second chamber is positioned to provide an irregular flow of the vapor so as to mix the vapor and the carrier gas into a substantially uniform vapor/carrier gas composition;
directing the substantially uniform vapor/carrier gas composition into a nozzle (49, 55, 65, 102);
directing the substantially uniform vapor/carrier gas composition out of an orifice of the nozzle toward a surface of a substrate having a temperature lower than the vapor, wherein the substrate is underlying the nozzle; and
heating the substantially uniform vapor/carrier gas composition, after the substantially uniform vapor/carrier gas composition is directed out of the nozzle, to maintain a vapor state.

2. The method of claim 1, wherein heating the powder comprises applying current to a component of the first chamber.

3. The method of claim 1, wherein the powder is a cadmium chalcogenide.

4. The method of claim 3, wherein the powder is cadmium telluride or cadmium sulfide.

5. The method of claim 1, wherein heating includes maintaining the first chamber at a temperature of at least 500 degrees C.

6. The method of claim 1, wherein the second chamber comprises one or more of distribution holes (48, 53, 63, 103).

7. A distributor assembly (300) comprising:
a first chamber (42, 100) for receiving a powder (500) and carrier gas (600);
a heating element associated with the first chamber and configured to vaporize at least a portion of the powder, wherein the first chamber comprises one or more first chamber walls which are permeable to the vapor and the carrier gas but impermeable to the powder;
a second chamber (44, 101) at least partially surrounding the first chamber and configured to receive the vapor and the carrier gas from the one or more first chamber walls of the first chamber and to provide a material flow sufficiently indirect to mix the vapor and the carrier gas into a substantially uniform vapor/carrier gas composition;
wherein the first chamber and the second chamber are tubular, and the first tubular chamber is disposed within the second tubular chamber such that the second tubular chamber at least partially sheaths the first tubular chamber;
a nozzle (49, 102) formed by a graphite cradle (45, 105) configured to receive the vapor/carrier gas composition from the second chamber;
an orifice of the nozzle configured to direct the uniform vapor/carrier gas composition toward a surface of a proximate substrate (400), wherein the substrate is underlying the nozzle; and
a heater tube (46A, 46B, 106A, 106B) proximate the graphite cradle, the heater tube heating the cradle to maintain a vapor state of the uniform vapor/carrier gas composition.

8. A system (200) for depositing a film on a substrate (400) comprising:
a material source (700, 800) connected to a distributor assembly (300) according to claim 7 for introducing a powder (500) and carrier gas (600) into the distributor assembly; and
a conveyor for transporting the substrate sufficiently proximate to the distributor assembly such that the vapor may be deposited on the substrate as a film.

9. The distributor assembly of claim 7 or the system of claim 8, wherein the one or more first chamber walls comprise the heating element, which is heated by resistive heating.

10. The distributor assembly of claim 7 or the system of claim 8, wherein the heating element is capable of maintaining the first chamber at a temperature of at least 500 degrees C.

11. The distributor assembly of claim 7 or the system of claim 8, wherein the second chamber comprises one or more distribution holes (48, 103).

12. The distributor assembly of claim 7 or the system of claim 8, wherein the chambers are provided as a plurality of successively shrouded tubes.

13. The distributor assembly of claim 7 or the system of claim 8, wherein the first chamber is a heated tube, wherein the second chamber is a tube larger than the first heated tube and the first heated tube is disposed within the second tube.

14. The distributor assembly of claim 7 or the system of claim 8, wherein the second chamber comprises walls that are substantially impermeable to the vapor and the carrier gas.

## Patentansprüche

1. Verfahren zur Abscheidung eines Materials auf einem Substrat (400), das Folgendes umfasst:
Einführen eines Pulvers (500) und eines Trägergases (600) in eine erste Kammer (42, 52, 62, 100), wobei die erste Kammer ein beheiztes Rohr ist;
Erhitzen des Pulvers, sodass zumindest ein Teil des Pulvers zu Dampf verdampft; wobei die erste Kammer eine oder mehrere erste Kammerwände umfasst, die durchlässig für den Dampf und das Trägergas sind, aber nicht durchlässig für das Pulver sind;
Leiten eines Gemischs aus dem Dampf und dem Trägergas durch die eine oder mehreren ersten Kammerwände der ersten Kammer und in eine zweite Kammer (44, 57, 67, 101), wobei die zweite Kammer rohrförmig ist und außerhalb der ersten Kammer positioniert ist, sodass die zweite rohrförmige Kammer zumindest einen Teil der ersten Kammer ummantelt, und wobei die zweite Kammer positioniert ist, um einen unregelmäßigen Dampfstrom bereitzustellen, um den Dampf und das Trägergas zu einer im Wesentlichen gleichförmigen Dampf/Trägergas-Zusammensetzung zu mischen;
Leiten der im Wesentlichen gleichförmigen Dampf/Trägergas-Zusammensetzung in eine Düse (49, 55, 65, 102) ;
Leiten der im Wesentlichen gleichförmigen Dampf/Trägergas-Zusammensetzung aus einer Öffnung der Düse heraus in Richtung einer Oberfläche eines Substrats mit einer Temperatur, die niedriger als die des Dampfes ist, wobei das Substrat unter der Düse liegt; und Erhitzen der im Wesentlichen gleichförmigen Dampf/Trägergas-Zusammensetzung, nachdem die Dampf/Trägergas-Zusammensetzung aus der Düse herausgeleitet wird, um einen Dampfzustand zu erhalten.

2. Verfahren nach Anspruch 1, wobei Erhitzen des Pulvers Anlegen eines Stroms an eine Komponente der ersten Kammer umfasst.

3. Verfahren nach Anspruch 1, wobei das Pulver ein Cadmiumchalcogenid ist.

4. Verfahren nach Anspruch 3, wobei das Pulver Cadmiumtellurid oder Cadmiumsulfid ist.

5. Verfahren nach Anspruch 1, wobei Erhitzen Halten der ersten Kammer bei einer Temperatur von mindestens 500 Grad C umfasst.

6. Verfahren nach Anspruch 1, wobei die zweite Kammer ein oder mehrere Verteilungslöcher (48, 53, 63, 103) umfasst.

7. Verteileranordnung (300), die Folgendes umfasst:
eine erste Kammer (42, 100) zum Aufnehmen eines Pulvers (500) und eines Trägergases (600);
ein Heizelement in Verbindung mit der ersten Kammer und ausgelegt zum Verdampfen zumindest eines Teils des Pulvers, wobei die erste Kammer eine oder mehrere erste Kammerwände umfasst, die durchlässig für den Dampf und das Trägergas sind, aber nicht durchlässig für das Pulver sind;
eine zweite Kammer (44, 101), die die erste Kammer zumindest teilweise umgibt und ausgelegt ist zum Aufnehmen des Dampfes und des Trägergases von der einen oder den mehreren ersten Kammerwänden der ersten Kammer und zum Bereitstellen eines Materialstroms, der ausreichend indirekt ist, um den Dampf und das Trägergas zu einer im Wesentlichen gleichförmigen Dampf/Trägergas-Zusammensetzung zu mischen; wobei die erste Kammer und die zweite Kammer rohrförmig sind, und wobei die erste rohrförmige Kammer innerhalb der zweiten rohrförmigen Kammer angeordnet ist, sodass die zweite rohrförmige Kammer die erste rohrförmige Kammer zumindest teilweise ummantelt;
eine Düse (49, 102), gebildet durch ein Graphitgerüst (45, 105), ausgelegt zum Aufnehmen der Dampf/Trägergas-Zusammensetzung aus der zweiten Kammer;
wobei eine Öffnung der Düse dazu ausgelegt ist, die gleichförmige Dampf/Trägergas-Zusammensetzung in Richtung einer Oberfläche eines nahen Substrats (400) zu leiten, wobei das Substrat unter der Düse liegt; und
ein Heizerrohr (46A, 46B, 106A, 106B) nahe dem Graphitgerüst, wobei das Heizerrohr das Gerüst erhitzt, um einen Dampfzustand der Dampf/Trägergas-Zusammensetzung zu erhalten.

8. System (200) zur Abscheidung eines Filmes auf einem Substrat (400), das Folgendes umfasst:
eine Materialquelle (700, 800), verbunden mit einer Verteileranordnung (300) nach Anspruch 7 zum Einführen eines Pulvers (500) und eines Trägergases (600) in die Verteileranordnung; und
ein Förderer zum Transportieren des Substrats, ausreichend nahe an der Verteileranordnung, sodass der Dampf als ein Film auf dem Substrat abgeschieden werden kann.

9. Verteileranordnung nach Anspruch 7 oder System nach Anspruch 8, wobei die eine oder die mehreren ersten Kammerwände das Heizelement umfassen, das durch Widerstandsheizen erhitzt wird.

10. Verteileranordnung nach Anspruch 7 oder System nach Anspruch 8, wobei das Heizelement in der Lage ist, die erste Kammer bei einer Temperatur von mindestens 500 Grad C zu halten.

11. Verteileranordnung nach Anspruch 7 oder System nach Anspruch 8, wobei die zweite Kammer ein oder mehrere Verteilungslöcher (48, 103) umfasst.

12. Verteileranordnung nach Anspruch 7 oder System nach Anspruch 8, wobei die Kammern als mehrere sich nacheinander umschließende Rohre bereitgestellt sind.

13. Verteileranordnung nach Anspruch 7 oder System nach Anspruch 8, wobei die erste Kammer ein beheiztes Rohr ist, wobei die zweite Kammer ein Rohr ist, das größer als das erste beheizte Rohr ist und wobei das erste beheizte Rohr innerhalb des zweiten Rohres angeordnet ist.

14. Verteileranordnung nach Anspruch 7 oder System nach Anspruch 8, wobei die zweite Kammer Wände umfasst, die im Wesentlichen nicht durchlässig für den Dampf und das Trägergas sind.

## Revendications

1. Procédé de dépôt d'une matière sur un substrat (400), comprenant :
l'introduction d'une poudre (500) et d'un gaz vecteur (600) dans une première chambre (42, 52, 62, 100), la première chambre étant un tube chauffé ;
le chauffage de la poudre de sorte qu'au moins une partie de la poudre se vaporise en une vapeur ; la première chambre comprenant une ou plusieurs parois de première chambre qui sont perméables à la vapeur et au gaz vecteur mais imperméables à la poudre ;
l'orientation d'un mélange de la vapeur et du gaz vecteur à travers la ou les parois de première chambre de la première chambre et dans une seconde chambre (44, 57, 67, 101), la seconde chambre étant tubulaire et étant positionnée à l'extérieur de la première chambre de sorte que la seconde chambre tubulaire enveloppe au moins une partie de la première chambre, et la seconde chambre étant positionnée pour fournir un écoulement irrégulier de la vapeur de manière à mélanger la vapeur et le gaz vecteur en une composition de vapeur/gaz vecteur sensiblement uniforme ;
l'orientation de la composition de vapeur/gaz vecteur sensiblement uniforme dans une buse (49, 55, 65, 102) ;
l'orientation de la composition de vapeur/gaz vecteur sensiblement uniforme hors d'un orifice de la buse vers une surface d'un substrat ayant une température inférieure à celle de la vapeur, le substrat étant sous-jacent à la buse ; et
le chauffage de la composition de vapeur/gaz vecteur sensiblement uniforme, après que la composition de vapeur/gaz vecteur sensiblement uniforme ait été dirigée hors de la buse, pour maintenir un état de vapeur.

2. Procédé selon la revendication 1, le chauffage de la poudre comprenant l'application d'un courant à un composant de la première chambre.

3. Procédé selon la revendication 1, la poudre étant un chalcogénure de cadmium.

4. Procédé selon la revendication 3, la poudre étant un tellurure de cadmium ou un sulfure de cadmium.

5. Procédé selon la revendication 1, le chauffage comprenant le maintien de la première chambre à une température d'au moins 500 degrés C.

6. Procédé selon la revendication 1, la seconde chambre comprenant un ou plusieurs des trous de distribution (48, 53, 63, 103).

7. Ensemble distributeur (300) comprenant :
une première chambre (42, 100) destinée à recevoir une poudre (500) et un gaz vecteur (600) ;
un élément de chauffage associé à la première chambre et configuré pour vaporiser au moins une partie de la poudre, la première chambre comprenant une ou plusieurs parois de première chambre qui sont perméables à la vapeur et au gaz vecteur mais imperméables à la poudre ;
une seconde chambre (44, 101) entourant au moins partiellement la première chambre et configurée pour recevoir la vapeur et le gaz vecteur à partir de la ou des parois de première chambre de la première chambre et pour fournir un flux de matière suffisamment indirect pour mélanger la vapeur et le gaz vecteur en une composition de vapeur/gaz vecteur sensiblement uniforme ;
la première chambre et la seconde chambre étant tubulaires, et la première chambre tubulaire étant disposée à l'intérieur de la seconde chambre tubulaire de telle sorte que la seconde chambre tubulaire enveloppe au moins partiellement la première chambre tubulaire ;
une buse (49, 102) formée par un berceau en graphite (45, 105) configurée pour recevoir la composition de vapeur/gaz vecteur de la seconde chambre ;
un orifice de la buse configuré pour diriger la composition de vapeur/gaz vecteur uniforme vers une surface d'un substrat proche (400), le substrat étant sous-jacent à la buse ; et
un tube de chauffage (46A, 46B, 106A, 106B) à proximité du berceau en graphite, le tube de chauffage chauffant le berceau pour maintenir un état de vapeur de la composition de vapeur/gaz vecteur uniforme.

8. Système (200) pour déposer un film sur un substrat (400) comprenant :
une source de matière (700, 800) reliée à un ensemble distributeur (300) selon la revendication 7 pour introduire une poudre (500) et un gaz vecteur (600) dans l'ensemble distributeur ; et
un convoyeur pour transporter le substrat suffisamment près de l'ensemble de distribution pour que la vapeur puisse être déposée sur le substrat sous forme de film.

9. Ensemble distributeur selon la revendication 7 ou système selon la revendication 8, la ou les parois de première chambre comprenant l'élément de chauffage, qui est chauffé par chauffage résistif.

10. Ensemble distributeur selon la revendication 7 ou système selon la revendication 8, l'élément de chauffage étant capable de maintenir la première chambre à une température d'au moins 500 degrés C.

11. Ensemble distributeur selon la revendication 7 ou système selon la revendication 8, la seconde chambre comprenant un ou plusieurs trous de distribution (48, 103) .

12. Ensemble distributeur selon la revendication 7 ou système selon la revendication 8, les chambres étant prévues comme une pluralité de tubes successivement enveloppés.

13. Ensemble distributeur selon la revendication 7 ou système selon la revendication 8, la première chambre étant un tube chauffé, la seconde chambre étant un tube plus grand que le premier tube chauffé et le premier tube chauffé étant disposé à l'intérieur du second tube.

14. Ensemble distributeur selon la revendication 7 ou du système selon la revendication 8, la seconde chambre comprenant des parois qui sont sensiblement imperméables à la vapeur et au gaz vecteur.
